# EUROPEAN PATENT APPLICATION

(11) **EP 4 580 340 A1**
(43) Date of publication of application: **02.07.2025**
(21) Application number: 24205240.5
(22) Date of filing: 08.10.2024
(51) Int. Cl.: H10D 84/01, H10D 30/01, H10D 30/47, H10D 84/08, H10D 84/80, H10D 88/00, H01L 25/065, H10D 89/60, H10D 30/67

(54) **SEMICONDUCTOR DEVICE WITH POWER GATING ELEMENT**

(30) Priority: 29.12.2023 KR 20230196954
(71) Applicant: Samsung Electronics Co., Ltd, Suwon-si, Gyeonggi-do 16677 (KR)
(72) Inventor: LEE, Chang Seok, 16678 Suwon-si (KR); KIM, Sangwon, 16678 Suwon-si (KR); KIM, Joonseok, 16678 Suwon-si (KR); SEOL, Minsu, 16678 Suwon-si (KR)
(74) Representative: Elkington and Fife LLP

(57) **Abstract**

A semiconductor device includes a first semiconductor chip that includes a semiconductor substrate which includes a plurality of circuit elements and a wiring structure which is disposed on the semiconductor substrate, and the wiring structure includes a plurality of wiring layers and one or more power gating elements disposed in the plurality of wiring layers, and the power gating elements are transistors including channel portions, gate electrodes, source electrodes, and drain electrodes, and the channel portions include a two-dimensional semiconductor material.

## Description

### FIELD OF THE INVENTION

The disclosure relates to a semiconductor device, and more particularly, to a semiconductor device with a power gating element.

### BACKGROUND OF THE INVENTION

Power gating elements in semiconductor devices are elements that are included to reduce the power consumption of the semiconductor devices and improve efficiency of the semiconductor devices. In general, power gating elements are designed such that power loss is minimized and electrical characteristics are improved to more efficiently use power. These power gating elements are applied to various semiconductor devices.

### SUMMARY OF THE INVENTION

In general, power gating elements for semiconductor devices are formed on a semiconductor substrate in a front end of line ("FEOL"), and connecting circuits are formed through wiring layers on top of the substrate. However, in this structure, the size and number of power gating elements are limited since the power gating elements need to share the area of a semiconductor substrate with other semiconductor elements. Also, since the connecting circuits need to pass through the power gating elements disposed on the semiconductor substrates, the length and complexity of the wiring may increase.

The disclosure may provide an efficient arrangement of power gating elements in a semiconductor device.

Also, the disclosure may provide a reduced length of wiring for power gating of a semiconductor device.

A semiconductor device in an embodiment includes a first semiconductor chip that includes a semiconductor substrate which includes a plurality of circuit elements and a wiring structure which is disposed on the semiconductor substrate, and the wiring structure includes a plurality of wiring layers and power gating elements disposed in the plurality of wiring layers, and the power gating elements are transistors respectively including channel portions, gate electrodes, source electrodes, and drain electrodes, and the channel portions include a two-dimensional ("2D") semiconductor material.

A semiconductor device in an embodiment includes a circuit board that includes circuit wiring, a first semiconductor chip that is disposed on the circuit board, and a second semiconductor chip that is disposed on the first semiconductor chip, and the first semiconductor chip includes a semiconductor substrate which includes a plurality of circuit elements and a wiring structure which is disposed on the semiconductor substrate, and the wiring structure includes a plurality of wiring layers and a plurality of power gating elements disposed in the plurality of wiring layers, and the plurality of power gating elements is transistors respectively including channel portions, and the channel portions include a 2D semiconductor material, and the plurality of power gating elements includes N-type transistors and P-type transistors.

A semiconductor device in an embodiment includes a circuit board that includes circuit wiring, a first semiconductor chip that is disposed on the circuit board, and a second semiconductor chip that is disposed on the first semiconductor chip, and the first semiconductor chip includes a semiconductor substrate which includes a plurality of circuit elements and a wiring structure which is disposed on the semiconductor substrate, and the wiring structure includes a plurality of wiring layers and a plurality of power gating elements disposed in the plurality of wiring layers, and the plurality of power gating elements is transistors including a plurality of channel portions, and the plurality of power gating elements includes N-type transistors and P-type transistors, and channel portions of N-type transistors of the plurality of power gating elements among the plurality of channel portions include a 2D semiconductor material, and channel portions of P-type transistors of the plurality of power gating elements among the plurality of channel portions include the 2D semiconductor material or an oxide semiconductor.

By an embodiment, it is possible to form a sufficient number of power gating elements with a sufficient size by forming the power gating elements with a 2D material between wiring layers.

By an embodiment, it is possible to reduce the wiring length of a power gating circuit by forming power gating elements with a 2D material at appropriate locations within a wiring layer.

By an embodiment, it is possible to configure various power gating circuits including all of N-type elements and P-type elements by forming power gating elements with a 2D material.

### BRIEF DESCRIPTION OF THE DRAWINGS

The above and other exemplary embodiments, advantages and features of this disclosure will become more apparent by describing in further detail exemplary embodiments thereof with reference to the accompanying drawings.
FIG. 1 is a cross-sectional view of an embodiment of a semiconductor device including power gating elements based on a two-dimensional ("2D") material.
FIG. 2 is a block diagram of the semiconductor device of FIG. 1.
FIG. 3 is a cross-sectional view of an embodiment of a semiconductor device including power gating elements based on a 2D material.
FIGS. 4 and 5 are circuit diagrams illustrating embodiments of power gating circuits configured with semiconductor elements based on 2D materials.

### DETAILED DESCRIPTION

embodiments will now be described in detail with reference to the accompanying drawings such that those skilled in the art to which the disclosure belongs may easily practice them. However, the embodiments may be implemented in various different forms, and the disclosure is not limited to the embodiments to be described herein.

The drawings and description are to be regarded as illustrative in nature, and not as restrictive. Throughout this specification, identical constituent elements are denoted by the same reference symbol.

In the drawings, the sizes and thicknesses of the individual constituent elements may be randomly indicated for ease of explanation, and the disclosure is not necessarily limited to the sizes and thicknesses as shown in the drawings. In the drawings, the thickness of layers, films, panels, regions, etc., may be exaggerated for clarity. In the drawings, for ease of explanation, the thicknesses of some layers and areas may be exaggerated.

Expressions written in the singular forms in this specification are intended to encompass the plural forms unless clear expressions such as "a", "an", or "single" are used.

In the specification and the claims, the term "and/or" is intended to encompass arbitrary combinations of the terms "and" and "or" for it meaning and interpretation. For example, "A and/or B" may be understood as meaning "A, B, or A and B".

In the specification and the claims, the phrase "at least one of" is intended to encompass the meaning "at least one selected from a group of" for its meaning and interpretation. For example, "at least one A and B" may be understood as meaning "A, B, or A and B".

In this specification, the terms "first", "second", etc., may be used to describe various constituent elements, but these constituent elements are not limited by the terms. These terms are only used to distinguish one element from other elements. For example, a first constituent element may be referred to as a second constituent element, and similarly, a second constituent element may be referred to as a first constituent element, without departing from the scope of the disclosure.

When an element such as a layer, a film, a region, a substrate is referred to as being "on" another element, it may be directly on the other element or intervening elements may also be present. In contrast, when an element is referred to as being "directly on" another element, there are no intervening elements present. Further, it will be appreciated that, throughout the specification, when an element is "on" a target element, it may be disposed above or below the target element, and it does not necessarily mean that the element is disposed "above" or "on" in a direction opposite to the gravity.

For example, spatially relative terms, such as "below", "on", and the like, may be used to make it easy to describe the relationship between one element or constituent element and other constituent elements as shown in the drawings. Spatially relative terms are intended to encompass different orientations of a device in use or operation, in addition to the orientation depicted in the drawings. For example, if devices in the drawings is turned over, a device that is disposed "below" another device may be disposed "on" the other device. Thus, for example, the term "below" may encompass both an orientation that is above, as well as below. Since devices may be otherwise oriented, the spatially relative terms may be interpreted differently depending on their orientation.

When an element (or a region, a layer, a portion, etc.) is referred to as being "connected" or "coupled" to another element, it may be directly on, or be directly connected or coupled to the other element, or intervening elements may be disposed therebetween.

The terms "connected to" or "coupled to" may encompass physical or electrical connections or coupling.

Unless otherwise defined, all terms (including technical and scientific terms) used in this disclosure have the same meaning as commonly understood by those skilled in the art to which the disclosure pertain. It will be further understood that terms, such as those defined in commonly-used dictionaries, should be interpreted as having a meaning that is consistent with their meaning in the context of the relevant art and will not be interpreted in an idealized or overly formal sense unless expressly so defined herein.

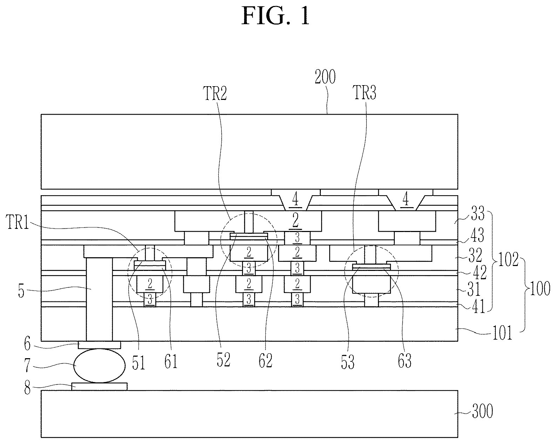

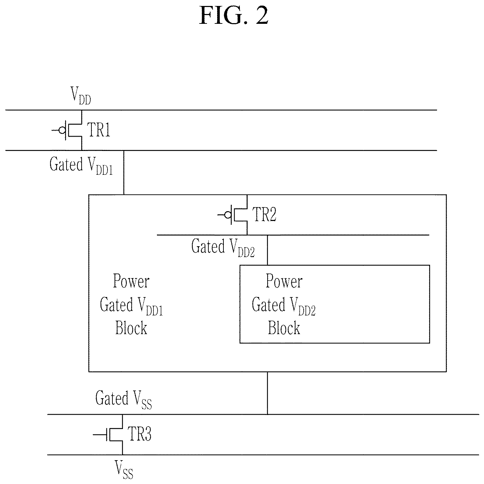

FIG. 1 is a cross-sectional view of an embodiment of a semiconductor device including power gating elements based on a two-dimensional ("2D") material. FIG. 2 is a block diagram of the semiconductor device of FIG. 1.

Referring to FIG. 1, a semiconductor device in an embodiment may include a circuit board 300, a first semiconductor chip 100, and a second semiconductor chip 200.

The circuit board 300 may be a printed circuit board ("PCB"), and may be a base for disposing (e.g., mounting) the first semiconductor chip 100 and the second semiconductor chip 200 thereon.

The first semiconductor chip 100 may include a semiconductor substrate 101, and a wiring structure 102 thereon. The semiconductor substrate 101 may be a silicon substrate or a compound semiconductor substrate, and may include various elements formed in a front end of line ("FEOL") process. The wiring structure 102 may include a plurality of power gating elements TR1, TR2, and TR3 disposed in a plurality of wiring layers. The wiring structure 102 may be formed in a back end of line ("BEOL") process.

The wiring layers may include a plurality of lower inter-insulating layers 41, 42, and 43, a plurality of upper inter-insulating layers 31, 32, and 33, a plurality of metal lines 2, and a plurality of connection vias 3. The number of the lower inter-insulating layers 41, 42, and 43 may be two or fewer, or may be four or more, and the number of the upper inter-insulating layers 31, 32, and 33 may be two or fewer, or may be four or more. The plurality of metal lines 2 and the connection vias 3 may be buried in the lower inter-insulating layers 41, 42, and 43 and the upper inter-insulating layers 31, 32, and 33 so as to constitute circuit wiring. The lower inter-insulating layers 41, 42, and 43 may have one or more functions of the function of a passivation layer, the function of an etch stop layer, or the function of a diffusion barrier layer, and may include or consist of a material such as SiCN. The upper inter-insulating layers 31, 32, and 33 may include or consist of SiO₂, SiNx, etc.

The power gating elements TR1, TR2, and TR3 may be transistors respectively including source electrodes, drain electrodes, gate electrodes, and channel portions. At least one of the power gating elements TR1, TR2, and TR3 may include a channel portion 51, 52, or 53 including or consisting of a 2D material having semiconductor properties (hereinafter, also referred to as a "2D semiconductor material"), and a gate insulating layer 61, 62, or 63 disposed below the channel portion 51, 52, or 53. In the description, the 2D material may mean a crystalline material consisting of single- or few-layer atoms, in which the in-plane interatomic interactions are much stronger than those along the stacking direction. The number of the power gating elements TR1, TR2, and TR3 may be two or fewer, or may be four or more, and may be dispersedly disposed in multiple wiring layers in the wiring structure 102.

In embodiments, the 2D semiconductor material, which includes in the channel portions 51, 52, and 53, may include the transition metal dichalcogenide ("TMD") family, alloys in which transition metals are combined with S and Se which are chalcogenide elements, and other 2D materials. The TMD family may include MoS₂, MoSe₂, MoTe₂, WS₂, WSe₂, WTe₂, ZrS₂, ZrSe₂, HfS₂, HfSe₂, NbSe₂, ReSe₂, PtS₂, PtSe₂, PdSe₂, PdTe₂, VS₂, VSe₂, FeSe₂, FeTe₂, etc. The alloys in which transition metals are combined with S and Se which are chalcogenide elements may include MoS(x)Se(1-x), WS(x)Se (1-x), or the like (where, 0<x<1). Other 2D materials may include Graphene, GaSe, GaTe₂, SnSe, Bi₂Se₃, Bi₂O₂Se, Silicene, Stanene, Tellurene, Borophene, Antimonene, etc. The channel portions 51, 52, and 53 may be formed by forming layers of the 2D semiconductor material on insulating layers by a method such as deposition and performing patterning into predetermined shapes by a method such as photo-etching.

The channel portions 51, 52, and 53 may include a double layer including or consisting of two different 2D materials.

Some of the channel portions 51, 52, and 53, e.g., the first and second channel portions 51 and 52, may include or consist of an oxide semiconductor, and the others, e.g., the third channel portion 53 may include or consist of a 2D semiconductor material. In embodiments, the oxide semiconductor may include ZnO, In₂O₃, TiO₂, Ga₂O₃, VOx, indium zinc oxide ("IZO")(InZnO), indium gallium zinc oxide ("IGZO"), indium zinc aluminum oxide ("IZAO"), SnO, Cu2O, NiO, etc.

The 2D semiconductor material which is included in the channel portions 51, 52, and 53 may include three or fewer 2D semiconductor material layers. This is because when four or more 2D semiconductor material layers are stacked, the electrical characteristics may become similar to a bulk material.

The gate insulating layers 61, 62, and 63 which are disposed below the channel portions 51, 52, and 53 may include or consist of a high-dielectric constant dielectric material such as Al₂O₃. In some embodiments, the gate insulating layers 61, 62, and 63 may be omitted, and the lower inter-insulating layers 41, 42, and 43 may serve as gate insulating layers. Since the 2D semiconductor material is stabler than the oxide semiconductor, barrier layers do not necessarily need to be formed.

The power gating elements TR1, TR2, and TR3 may include the source electrodes, the drain electrodes, and the gate electrodes formed with the metal lines 2 and the connection vias 3. The source electrodes and drain electrodes of the power gating elements TR1, TR2, and TR3 are connected to an external power source through the metal lines 2 and the connection vias 3, or may be connected to various elements or other power gating elements TR1, TR2, and TR3 formed on the semiconductor substrate 101. The gate electrodes may receive on/off signals from an element on the semiconductor substrate 101 through the metal lines 2 and the connection vias 3, thereby turning on and off the power gating elements TR1, TR2, and TR3.

Some of the power gating elements TR1, TR2, and TR3, e.g., the first and second power gating elements TR1 and TR2, may be headers for controlling the connection of a power voltage V_{DD}, and the others, e.g., the third power gating element TR3, may be footers for controlling the connection of a ground voltage Vss. The channel portions 51 and 52 of the first and second power gating elements TR1 and TR2 which are headers may include or consist of a P-type 2D semiconductor material or a P-type oxide semiconductor, and the third power gating element TR3 which is a footer may include or consist of an N-type 2D semiconductor material. Example of the P-type 2D semiconductor material may include SnS, SnSe₂, GaSe, WS₂, WSe₂, MoTe₂, WTe₂, HfSe₂, ReS₂, ZrSe₂, PtSe₂, FeSe₂, NiTe₂, GaTe₂, Germanium, Selenium, Tellurene, Phosphorene, Arsenene, Silicene, Stanene, Borophene, or the like, and embodiments of the N-type 2D semiconductor material may include MoS₂, TaS₂, NbSe₂, MoSe₂, MoS₂₋ₓSeₓ, TiS₂, TaSe₂, ZrS₂, HfS₂, ReSe₂, PtS₂, PdSe₂, PdTe₂, VS₂, VSe₂, FeTe₂, Antimonene, or the like. Also, the above 2D semiconductor materials may be used by adjusting the metals in contact, or by modulating them into P-type or N-type by methods such as electrostatic doping or dipole doping. In some embodiments, the above 2D semiconductor materials may be used by modulating them into an ambipolar semiconductor having all of P-type and N-type characteristics. In addition to the above-mentioned 2D semiconductor materials, 2D semiconductor materials such as Bi₂Se₃, Bi₂O₂Se, or the like may also be used as materials for the channel portions 51, 52, and 53 by modulating them so as to have P-type and N-type characteristics.

The first semiconductor chip 100 may include a plug 5 and a plug pad 6 for applying power. The plug 5 may pass through at least a portion of the semiconductor substrate 101 and the wiring structure 102 and be connected to a metal line 2 which is connected to at least one of the power gating elements TR1, TR2, and TR3, e.g., the first power gating element TR1. The plug pad 6 may be connected to a wiring pad 8 of the circuit board 300 through a connection member such as a ball bump 7.

The first semiconductor chip 100 may include connection pads 4 for connection with the second semiconductor chip 200. The connection pads 4 may be directly bonded to connection pads (not shown in the drawings) of the second semiconductor chip 200, or may be connected to them by connection members. The first semiconductor chip 100 may be a system semiconductor chip including logic circuits, and the second semiconductor chip 200 may be a memory chip such as a dynamic random access memory ("DRAM"), a static random access memory ("SRAM"), a phase-change random access memory ("PRAM"), a not-and ("NAND") flash, etc.

By forming the power gating elements TR1, TR2, and TR3 within the wiring layer in the BEOL process, the semiconductor device in an embodiment may utilize the effective area of the semiconductor substrate 101 for forming other circuit elements, thereby improving the integration of the circuit elements. Furthermore, the power gating elements TR1, TR2, and TR3 may be distributed across multiple wiring layers of the wiring structure 102, so there are fewer restrictions on their size or number. Accordingly, a sufficient number of power gating elements TR1, TR2, and TR3 with sufficient sizes may be formed. Further, it is possible to reduce the length of wiring for power gating by forming the power gating elements TR1, TR2, and TR3 at appropriate positions in the wiring layers. Furthermore, it is possible to form all of N-type and P-type elements by forming the channel portions of power gating elements with a 2D semiconductor material. Accordingly, it is possible to configure various power gating circuits as well as headers and footers.

Referring to FIG. 2, the semiconductor device in the embodiment may include two power blocks. The first power gating element TR1 may apply or block a first power voltage (Gated V_{DD1}) to the first power block (also referred to as "Power Gated V_{DD1} Block"), and the second power gating element TR2 may apply or block a second power voltage (Gated V_{DD2}) to the second power block (also referred to as "Power Gated V_{DD2} Block"). The ground voltage Vss may be connected to or disconnected from the first power block and the second power block by the third power gating element TR3. In some embodiments, the semiconductor device may include one power block, or three or more power blocks, and the power blocks may be connected to the power voltage V_{DD} in parallel, or in a combination series and parallel.

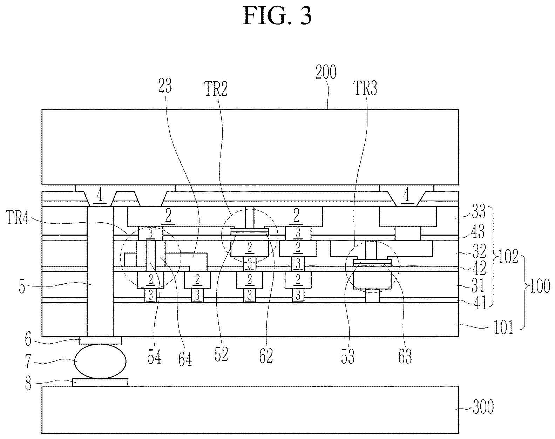

FIG. 3 is a cross-sectional view of an embodiment of a semiconductor device including power gating elements based on a 2D material.

In the embodiment of FIG. 3, the plug 5 may pass through the entirety of the semiconductor substrate 101 and the entirety of the wiring structure 102 so as to be connected to a connection pad 4 on the wiring structure 102, such that the power source may be directly connected to the second semiconductor chip 200. The connection pad 4 connected to the plug 5 may be connected to a fourth power gating element TR4 and the second power gating element TR2 through the metal lines 2. In other words, the power source may be connected in parallel with the first semiconductor chip 100 and the second semiconductor chip 200 through the plug 5.

A channel portion 54 of the fourth power gating element TR4 may have a cylindrical or polygonal rod shape extending in a vertical direction, and a gate insulating layer 64 may surround the channel portion 54 in a horizontal direction. The channel portion 54 may also include or consist of a 2D semiconductor material or an oxide semiconductor mentioned above. When the channel portion 54 includes or consists of a 2D semiconductor material, it may have a shape in which a 2D semiconductor material layer covers the periphery of an insulator member having a cylindrical or polygonal rod shape.

A gate electrode 23 may be disposed around the periphery of the gate insulating layer 64, and may be connected to a circuit element of the semiconductor substrate 101 through the metal lines 2 and the connection vias 3. The gate electrode 23 may include or consist of the same material as that of the metal lines 2 and/or the connection vias 3 simultaneously. The source electrode and drain electrode of the fourth power gating element TR4 may be disposed above and below the channel portion 54, and may be part of the metal line 2 and/or the connection via 3. The fourth power gating element TR4 may connect or disconnect the power incoming through the plug 5 and the connection pad 4 to the circuit elements of the semiconductor substrate 101.

Another configuration is substantially the same as that of the semiconductor device in the embodiment of FIG. 2, and a detailed description thereof will not be made.

As described above, each power gating element may be disposed so as to have a horizontal channel or a vertical channel. An embodiment of a structure of a power gating element having a horizontal channel may be a bottom gate structure in which the gate is disposed below the channel, or a top gate structure in which the gate is disposed on the channel, as shown in FIGS. 1 and 3. Power gating elements with vertical channels may be modified in various forms.

In the semiconductor device in the embodiment, all of N-type and P-type elements may be formed by forming the channel portions of the power gating elements of a 2D semiconductor material. Since all of N-type and P-type elements may be formed as described above, it is possible to construct various types of power gating circuits.

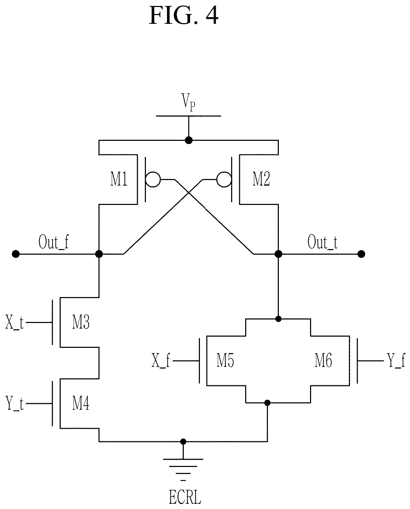

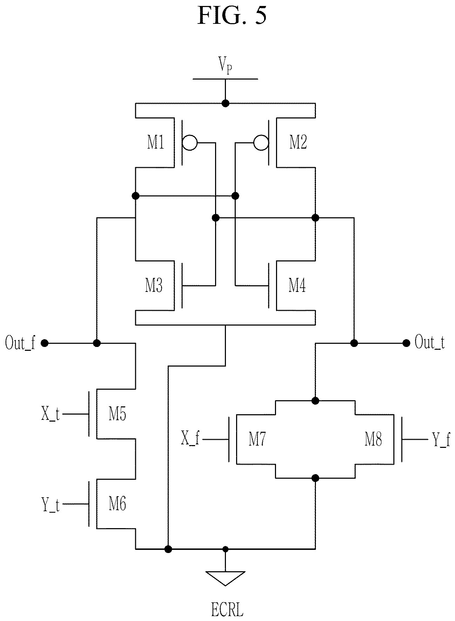

FIGS. 4 and 5 are circuit diagrams illustrating embodiments of power gating circuits configured with semiconductor elements based on 2D materials.

FIGS. 4 and 5 shows embodiments of the case where power gating circuits consist of efficient charge recovery logic ("ECRL") circuits.

The ECRL circuit of FIG. 4 may consist of two P-type transistors M1 and M2 and four N-type transistors M3, M4, M5, and M6, and a power voltage may be applied through an input terminal Vp, and the controlled power voltage may be applied to a predetermined circuit element through output terminals Out_f and Out_t. In an embodiment, the N-type transistor M3 may receive an input signal through an input terminal X_t, the N-type transistor M4 may receive an input signal through an input terminal Y_t, the N-type transistor M5 may receive an input signal through an input terminal X_f, the N-type transistor M6 may receive an input signal through an input terminal Y_f, for example.

The ECRL circuit of FIG. 5 may consist of two P-type transistors M1 and M2 and six N-type transistors M3, M4, M5, M6, M7, and M8, and a power voltage may be applied through an input terminal Vp, and the controlled power voltage may be applied to a predetermined circuit element through output terminals Out_f and Out_t. In an embodiment, the N-type transistor M5 may receive an input signal through an input terminal X_t, the N-type transistors M6 may receive an input signal through an input terminal Y_t, the N-type transistor M7 may receive an input signal through an input terminal X_f, the N-type transistor M8 may receive an input signal through an input terminal Y_f, for example.

Although the embodiments of the disclosure have been described above with reference to the accompanying drawings, it should be appreciated by those skilled in the art to which the disclosure pertain that the disclosure may be implemented in other predetermined forms without changing the technical idea or the essential features. Accordingly, it should be appreciated that the above-described embodiments are illustrative and non-restrictive in every respect.

## Claims

1. A semiconductor device comprising:
a first semiconductor chip including:
a semiconductor substrate including:
a plurality of circuit elements; and
a wiring structure which is disposed on the semiconductor substrate, the wiring structure including:
a plurality of wiring layers; and
power gating elements disposed in the plurality of wiring layers, the power gating elements being transistors respectively including:
channel portions each including a two-dimensional semiconductor material;
gate electrodes;
source electrodes; and
drain electrodes.

2. The semiconductor device of claim 1, wherein:
the power gating elements include a first power gating element and a second power gating element, and
the first power gating element is a P-type transistor, and the second power gating element is an N-type transistor.

3. The semiconductor device of claim 2, wherein:
a channel portion of the first power gating element among the channel portions includes at least one of SnS, SnSe₂, GaSe, WS₂, WSe₂, MoTe₂, WTe₂, HfSe₂, ReS₂, ZrSe₂, PtSe₂, FeSe₂, NiTe₂, GaTe₂, Germanium, Selenium, Tellurene, Phosphorene, Arsenene, Silicene, Stanene, and Borophene, and
a channel portion of the second power gating element among the channel portions includes at least one of MoS₂, TaS₂, NbSe₂, MoSe₂, MoS₂₋ₓSeₓ, TiS₂, TaSe₂, ZrS₂, HfS₂, ReSe₂, PtS₂, PdSe₂, PdTe₂, VS₂, VSe₂, FeTe₂, and Antimonene.

4. The semiconductor device of claim 2, wherein:
a channel portion of the first power gating element among the channel portions includes at least one of MoS₂, MoSe₂, MoTe₂, WS₂, WSe₂, WTe₂, ZrS₂, ZrSe₂, HfS₂, HfSe₂, NbSe₂, ReSe₂, PtS₂, PtSe₂, PdSe₂, PdTe₂, VS₂, VSe₂, FeSe₂, FeTe₂, MoS(x)Se(1-x) (wherein 0<x<1), WS(x)Se(1-x) (wherein 0<x<1), Graphene, GaSe, GaTe₂, SnSe, Bi₂Se₃, Bi₂O₂Se, Silicene, Stanene, Tellurene, Borophene, and Antimonene, and has P-type semiconductor characteristics, and
a channel portion of the second power gating element among the channel portions includes at least one of MoS₂, MoSe₂, MoTe₂, WS₂, WSe₂, WTe₂, ZrS₂, ZrSe₂, HfS₂, HfSe₂, NbSe₂, ReSe₂, PtS₂, PtSe₂, PdSe₂, PdTe₂, VS₂, VSe₂, FeSe₂, FeTe₂, MoS(x)Se(1-x) (wherein 0<x<1), WS(x)Se(1-x) (wherein 0<x<1), Graphene, GaSe, GaTe₂, SnSe, Bi₂Se₃, Bi₂O₂Se, Silicene, Stanene, Tellurene, Borophene, and Antimonene, and has N-type semiconductor characteristics.

5. The semiconductor device of any of claims 2 to 4, wherein:
the first power gating element is a header, and the second power gating element is a footer.

6. The semiconductor device of any preceding claim, wherein:
the power gating elements include a first power gating element and a second power gating element, and
a channel portion of the first power gating element among the channel portions includes an oxide semiconductor, and a channel portion of the second power gating element among the channel portions includes the two-dimensional semiconductor material.

7. The semiconductor device of claim 6, wherein:
the channel portion of the second power gating element includes at least one of MoS₂, MoSe₂, MoTe₂, WS₂, WSe₂, WTe₂, ZrS₂, ZrSe₂, HfS₂, HfSe₂, NbSe₂, ReSe₂, PtS₂, PtSe₂, PdSe₂, PdTe₂, VS₂, VSe₂, FeSe₂, FeTe₂, MoS(x)Se(1-x) (wherein 0<x<1), WS(x)Se(1-x) (wherein 0<x<1), Graphene, GaSe, GaTe₂, SnSe, Bi₂Se₃, Bi₂O₂Se, Silicene, Stanene, Tellurene, Borophene, and Antimonene.

8. The semiconductor device of claim 7, wherein:
the channel portion of the first power gating element includes at least one of ZnO, In₂O₃, TiO₂, Ga₂O₃, VOx, indium zinc oxide (InZnO), indium gallium zinc oxide, indium zinc aluminum oxide, SnO, Cu2O, and NiO.

9. The semiconductor device of any preceding claim, wherein:
each of the plurality of wiring layers comprises:
a lower inter-insulating layer;
an upper inter-insulating layer on the lower inter-insulating layer; and
metal lines and connection vias buried in the lower inter-insulating layer and the upper inter-insulating layer.

10. The semiconductor device of claim 9, wherein:
the gate electrodes, the source electrodes, and the drain electrodes of the power gating elements include a same material as a material of at least some of the metal lines and the connection vias.

11. The semiconductor device of claim 10, further comprising:
a circuit board which includes wiring lines and a wiring pad,
wherein the first semiconductor chip includes a plug which passes through at least a portion of the semiconductor substrate and the wiring structure, and a plug pad which is disposed on a lower surface of the semiconductor substrate and is connected to the plug, and
the first semiconductor chip is disposed on the circuit board, and further includes a bump which connects the wiring pad and the plug pad.

12. The semiconductor device of claim 11, further comprising:
a second semiconductor chip bonded to an upper surface of the first semiconductor chip,
wherein the second semiconductor chip receives power through the plug, and optionally wherein:
the plug passes through an entirety of the semiconductor substrate and an entirety of the wiring structure, and
the plug is connected to the second semiconductor chip through a connection pad so as to apply the power to the second semiconductor chip.

13. The semiconductor device of any of claims 2 to 12, wherein:
in the channel portions, at least one and no more than three layers of the two-dimensional semiconductor material are stacked.

14. The semiconductor device of any preceding claim, wherein:
the power gating elements include a plurality of N-type transistors and a plurality of P-type transistors, and
the plurality of N-type transistors and the plurality of P-type transistors constitute an efficient charge recovery logic circuit.

15. A device comprising:
a circuit board which includes circuit wiring;
a semiconductor device according to any preceding claim disposed on the circuit board.
